# EUROPÄISCHE PATENTANMELDUNG

(11) **EP 4 478 594 A1**
(43) Veröffentlichungstag der Anmeldung: **18.12.2024**
(21) Anmeldenummer: 24177127.8
(22) Anmeldetag: 21.05.2024
(51) Int. Cl.: H02M 1/10

(54) **VERSORGUNGSSCHALTUNG FÜR EIN MESSGERÄT UND MESSGERÄT**

(30) Priorität: 15.06.2023 DE 102023205626
(71) Anmelder: Siemens Aktiengesellschaft, 80333 München (DE)
(72) Erfinder: Braun, Markus, 90592 Schwarzenbruck (DE); Fischer, Alexander, 90449 Nürnberg (DE); Geyer, Michael, 91207 Lauf an der Pegnitz (DE); Günther, Simon, 90429 Nürnberg (DE); Haspel, Markus, 90429 Nürnberg (DE)
(74) Vertreter: Siemens Patent Attorneys

(57) **Zusammenfassung**

Es wird eine Versorgungsschaltung (4) für ein Messgerät (1) vorgeschlagen, welche Eingänge einer primären Energieversorgung (L1, L2, L3, N) und einer zusätzlichen Energieversorgung (L_{AUX} N_{AUX}) umfasst. Beide Energieversorgungen sind in der Versorgungsschaltung (4) zu einem Versorgungssignal zusammengeschaltet. Die Erfindung stellt eine aufwandsarme und fehlerunanfällige Realisierung einer Energieversorgung mit Redundanz zur Weiterversorgung bei Ausfall der primären Energiequelle dar.

## Beschreibung

Die Erfindung betrifft eine Schaltung zur Energieversorgung eines Messgeräts und ein Messgerät mit einer derartigen Versorgungsschaltung.

Messgeräte, die Messgrößen eines Stromkreises erfassen, sind häufig mit einer Energieversorgung ausgestattet, die sich aus dem überwachten Stromkreis speist. Anforderungen an derartige Versorgungslösungen sind teilweise auch Gegenstand von Normen, z.B. der Europäische Messgeräterichtlinie 2014/32/EU (MID) .

Derartige Lösungen haben den Nachteil, dass bei Ausfall der Messspannung auch die Energieversorgung des Geräts nicht mehr gewährleistet ist. Insbesondere ist dann auch die Kommunikation zum und vom Gerät unterbrochen. Der externe Zugriff auf Messdaten, die ggf. zur Diagnose des Messspannungsausfalls oder zur korrekten Verbrauchsermittlung benötigt werden, ist nicht sichergestellt.

Aus der Schrift DE 102009048670 A1 ist bekannt, als zusätzliche Energiequelle einen Speicher zu verwenden, der über die Hauptenergiequelle (z.B. abgeleitet aus der Messspannung) aufgeladen wird. Die Versorgung aus der Hauptenergiequelle wird überwacht. Bei Wegfall dieser Energieversorgung schaltet das Messgerät mittels Umschalteinrichtung auf Speicherbetrieb um.

Es besteht ein Bedarf an aufwandsarmen und flexiblen Lösungen zu Sicherung der Energieversorgung von Messgeräten.

Diese Aufgabe wird gelöst durch eine Versorgungsschaltung für ein Messgerät nach Anspruch 1 und ein Messgerät mit einer derartigen Versorgungsschaltung nach Anspruch 7.

Erfindungsgemäß wird eine Versorgungsschaltung für ein Messgerät vorgeschlagen, welche Eingänge - im Folgenden auch als "Versorgungseingänge" bezeichnet - einer ersten Energieversorgung und einer zweiten Energieversorgung umfasst. Diese Energieversorgungen werden im Folgenden als "primäre" und "zusätzliche" Energieversorgung bezeichnet. Der Grund dafür ist, dass die erste Energieversorgung dafür ausgestaltet ist, das Messgerät im Regelbetrieb mit Energie zu versorgen ("primäre Energieversorgung"), während die zweite ("zusätzliche Energieversorgung") nicht notwendigerweise für einen Dauerbetrieb des Messgeräts ausgebildet sein muss. Es kann sich hierbei auch um eine Energieversorgung handeln, die dafür ausgelegt ist, den Betrieb des Messgeräts für eine begrenzte Zeitdauer aufrechtzuerhalten, wenn die primäre Energieversorgung ausfällt. Erfindungsgemäß sind beide Energieversorgungen in der Versorgungsschaltung zu einem (einzigen) Versorgungssignal zusammengeführt bzw. für die Bereitstellung eines (einzigen) Versorgungssignals zusammengeschaltet, durch welches dann die Elektronik des Messgeräts (z.B. MCU) gespeist wird.

Durch Integration der beiden Energieversorgungen in der Versorgungsschaltung zu einem Versorgungssignal ist für die gespeiste Elektronik bzw. MCU nur ein Versorgungseingang notwendig. D.h. die Elektronik "sieht" nur eine Energiequelle. Ein aufwändiges Überwachen verschiedener Energiequellen und ggf. Umschalten zu einer Hilfsspannungsquelle (wie zum Beispiel in der DE 102009048670 A1) ist nicht erforderlich. Diese Lösung ist somit aufwandsärmer und letztlich auch weniger fehleranfällig als der Stand der Technik.

Die Zusammenführung der Energiequellen durch die Versorgungsschaltung zu einem einzigen Versorgungssignal ist dabei so zu verstehen, dass durch die Schaltung die Versorgungseingänge in einer Weise zusammengeschaltet werden, dass sich nur die für die Elektronik erforderlichen Verbindungen bzw. Leitungen ergeben. Durch die Zusammenschaltung kann sich z.B. ein Zweipol bzw. eine zweipolige Schnittstelle ergeben. Konkret könnten dann die Eingänge der Energieversorgungen jeweils wenigstens einen Phasenleiter (z.B. auch drei) und einen Neutralleiter umfassen und die Zusammenführung mit einer Zusammenschaltung jeweils der Phasenleiter und der Neutralleiter der Energieversorgungen zu einem Phasenleiter und einem Neutralleiter (d.h. zwei Pole) realisiert sein. Es wäre aber u.U. auch denkbar, dass Elektronik mit Drehstrom versorgt werden soll. In diesem Fall hätte man im Zuge der Zusammenschaltung wenigstens drei Eingänge bzw. Leitungen (Zusammenschaltung aller Versorgungseingänge zu drei Phasenleiter und ggf. einem Neutralleiter) und der Drehstrom wäre dann z.B. als das "eine Versorgungssignal" im Sinne der Lehre der Ansprüche zu verstehen.

Gemäß einer Ausgestaltung des Erfindungsgegenstands sind für wenigstens eine der Energieversorgungen (vorzugsweise für beide) zwischen den Versorgungseingängen und der Zusammenschaltung Schaltelemente zum Schutz der Elektronik des Messgeräts vorgesehen. Dieser Schutz kann z.B. durch eine Parallelschaltung aus einem Kondensator einem Überspannungsableiter (z.B. Varistor), welche zwischen einem zu schützenden Phaseneingang und einem Neutralleitereingang angeordnet sind.

Gemäß einer Ausbildung des Erfindungsgegenstands liefert mindestens eine der Energieversorgungen Wechselspannung, und es ist für die wenigstens eine Energieversorgung zwischen den Eingängen und der Zusammenschaltung mindestens ein Schaltelement (z.B. Gleichrichterdiode) zur Spannungsgleichrichtung vorgesehen. Es können dabei für die Spannungsgleichrichtung auch beliebige dem Fachmann bekannte Schaltungen wie Einweggleichrichter, Brückengleichrichter, Mittelpunktgleichrichter etc. zum Einsatz kommen. Bei einer Kombination mit Elementen zum Schutz (z.B. Parallelschaltung aus Kondensator und Überspannungsableiter) ist das mindestens eine Schaltelement zur Gleichrichtung z.B. zwischen den Elementen zum Schutz und der schalttechnischen Zusammenführung der Energieversorgungen vorgesehen. Mit "Element" ist dabei ein Schaltelement bzw. ein Bauteil einer Schaltung gemeint.

Gemäß einer Ausgestaltung der erfindungsgemäßen Versorgungsschaltung ist sie mit einem der Zusammenführung der Energieversorgungen nachgelagerten Schalungsteil zur Glättung und/oder Filterung des Versorgungssignals gebildet.

Gemäß einer Ausgestaltung der erfindungsgemäßen Versorgungsschaltung ist sie mit einem der Zusammenführung der Energieversorgungen nachgelagerten Schaltungsteil zur Transformation des Versorgungssignals gebildet.

Die Erfindung betrifft auch ein Messgerät, z.B. ein sog. PMD (Power Metering & Monitoring Device), das mit einer erfindungsgemäßen Versorgungsschaltung gebildet ist. Dieses Messgerät kann dafür ausgestaltet sein, auf einen Stromkreis bezogene Messdaten zu erfassen und als primäre Energieversorgung dem Stromkreis Energie zu entnehmen.

Im Folgenden wir die Erfindung im Rahmen eines Ausführungsbeispiels beschrieben. Es zeigen
Fig. 1: Ein Messgerät für die Erfassung von auf einen Stromkreis bezogenen Messdaten, welches sich aus dem überwachten Stromkreis speist,
Fig. 2: eine erfindungsgemäße Versorgungsschaltung eines Messgeräts nach Fig. 1, welche neben der Speisung aus dem überwachten Stromkreis eine zusätzliche Energiequelle vorsieht,
Fig. 3: die Versorgungsschaltung aus Fig. 2 mit weiteren Schaltungsdetails,
Fig. 4: eine Prinzipdarstellung eines Messgeräts mit erfindungsgemäßer Energieversorgung, wobei eine Energieversorgung aus einer zusätzlichen Wechselspannungsquelle vorgesehen ist, und
Fig. 5: eine Prinzipdarstellung eines Messgeräts mit erfindungsgemäßer Energieversorgung, wobei eine Energieversorgung aus einer zusätzlichen Geleichspannungsquelle vorgesehen ist.

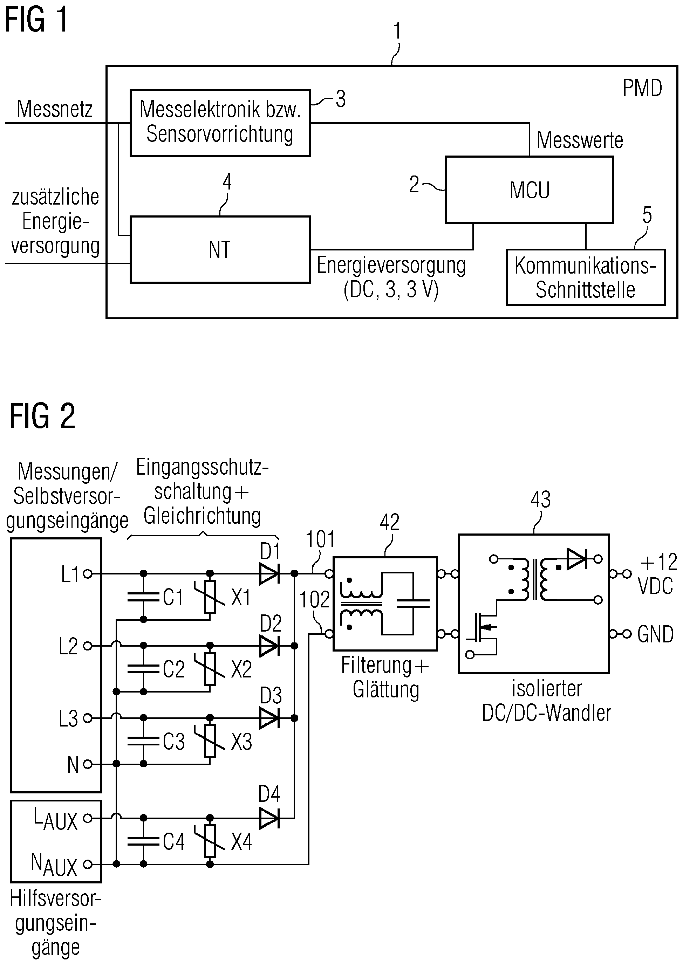

Fig. 1 zeigt ein Messgerät 1 für die Erfassung von auf einen Stromkreis bezogenen Messdaten. Häufig sind Messgeräte, die als PMDs (Power Metering & Monitoring Devices) bezeichnet werden und neben Strom- und Spannungswerten auch in der Regel Verbrauchsdaten ermitteln. Diese Ermittlung von Verbrauchsdaten kann z.B. für standardisiertes Abrechnen von verbrauchter Energie (z.B. nach der MID Richtlinie EN 50470-1/3 bzw. den Standards IEC TR 63213 oder IEC 61557-12) ausgestaltet sein. Generell ist aber die im Folgenden im Rahmen eines Ausführungsbeispiels beschriebene Erfindung aber für beliebige Messgeräte anwendbar, die sich aus einem Stromkreis speisen.

Das Messgerät 1 ist mit dem zu überwachenden Stromkreis bzw. Messnetz verbunden und erhält Messdaten, die durch eine Messelektronik bzw. Sensorvorrichtung 3 erfasst werden. Diese Messdaten werden durch einen Microkontroller bzw. eine MCU 2 weiterverarbeitet (z.B. Berechnung von Verbrauchsdaten). Die MCU ist zudem mit einer Schnittstelle 5 versehen, über die Daten übertragen oder ausgelesen werden können. Für die Energieversorgung der MCU 2 ist ein Netzteil bzw. eine Versorgungsschaltung NT vorgesehen. Dieses wird aus dem überwachten Stromkreis versorgt und liefert Gleichspannung mit 3,3 V an die MCU 2. Die Energieversorgung aus der Messspannung wird im Folgenden als primäre Energieversorgung bzw. primäre Energiequelle bezeichnet.

Zur Absicherung der Versorgung ist eine zusätzliche Energieversorgung der Versorgungsschaltung (Versorgungskreis) vorgesehen. Die zusätzliche Energieversorgung kann z.B. über einen weiteren Stromkreis - häufig als "Netzersatzanlage" oder "Ersatzstromversorgung" bezeichnet - erfolgen, der z.B. eine Wechselspannung (z.B. 230 V) liefert. Alternativ kann eine unterbrechungsfreie Stromversorgung - häufig als "USV" bzw. "Uninterruptible Power Supply" bezeichnet - zur Anwendung kommen. Häufig basieren diese USVs auf einer Batterie. Es ist auch denkbar, dass diese zusätzliche Energiequelle aus einem Energiespeicher besteht, der durch die primäre Energiequelle (Stromkreis) aufgeladen wurde bzw. wird (aufladbare Batterie oder Einzelkondensator).

Durch den zusätzlichen Versorgungseingang kann das Gerät über eine vom Messnetz unabhängige Phase (2.ter Stromkreis) oder USV weiterversorgt werden. Dadurch kann das Gerät einen Alarm bei Netzausfall an die Leitwarte senden und den Zeitraum auch länger detektieren. Somit sind eine lückenlose Überwachung und Digitalisierung von Zuständen der elektrischen Energieversorgung möglich.

In Fig. 2 ist dargestellt, wie die primäre und die zusätzliche Energieversorgung miteinander verknüpft sind. Es sind Phasen L1 - L3 und Neutralleiter N des überwachten Stromkreises dargestellt. Diesem werden parallel sowohl Messwerte als auch Energie zur Versorgung des Messgerätes entnommen. In Fig. 2 sind Elemente für die Energieversorgung des Messgeräts 1 aus Fig. 1 und insb. der MCU 2 gezeigt. Es ist für jede der Phasen L1 - L3 eine Parallelschaltung aus einem Kondensator (Kondensatoren C1 - C3) und einem Überspannungsableiter (z.B. Varistoren X1 - X3) vorgesehen, die vornehmlich dem Schutz der Elektronik des Messgeräts dient. Zu Gleichrichtung des Stroms ist der Parallelschaltung aus Kondensator und Überspannungsableiter jeweils eine Diode D1-D3 nachgeschaltet. Es ist eine zusätzliche Energiequelle bzw. Spannungsquelle mit Phasen- und Neutralleiteranschluss L_{AUX} bzw. N_{AUX} vorgesehen, die das Messgerät mit Wechselstrom versorgt. Die Phase L_{AUX} ist entsprechend den Phasen der primären Energieversorgung mit einer Parallelschaltung aus Kondensator und Überspannungsableiter C4 bzw. X4 und einer Diode D4 zur Gleichrichtung versehen. Die Gleichrichtung muss nicht mit einer Diode realisiert sein. Es können für die Spannungsgleichrichtung auch beliebige dem Fachmann bekannte Schaltungen wie Einweggleichrichter, Brückengleichrichter (Halbbrücke oder Vollbrücke), Mittelpunktgleichrichter etc. zum Einsatz kommen.

Die Phasen L1-L3 und L_{AUX} der Energiequellen sind in Anschluss der Gleichrichtung miteinander verbunden. Beide Neutralleiter N und N_{AUX} sind ebenfalls zusammengeführt. Somit ergeben sich zwei Anschlüsse 101 und 102 (bzw. ein Zweipol). Die Anschlüsse 101 und 102 sind mit einer Schaltung zum Filtern und Glätten 42 verbunden, der eine weitere Schaltung zur Spannungstransformation 43 auf einen für die MCU 2 geeigneten Spannungswert in Reihe geschaltet ist.

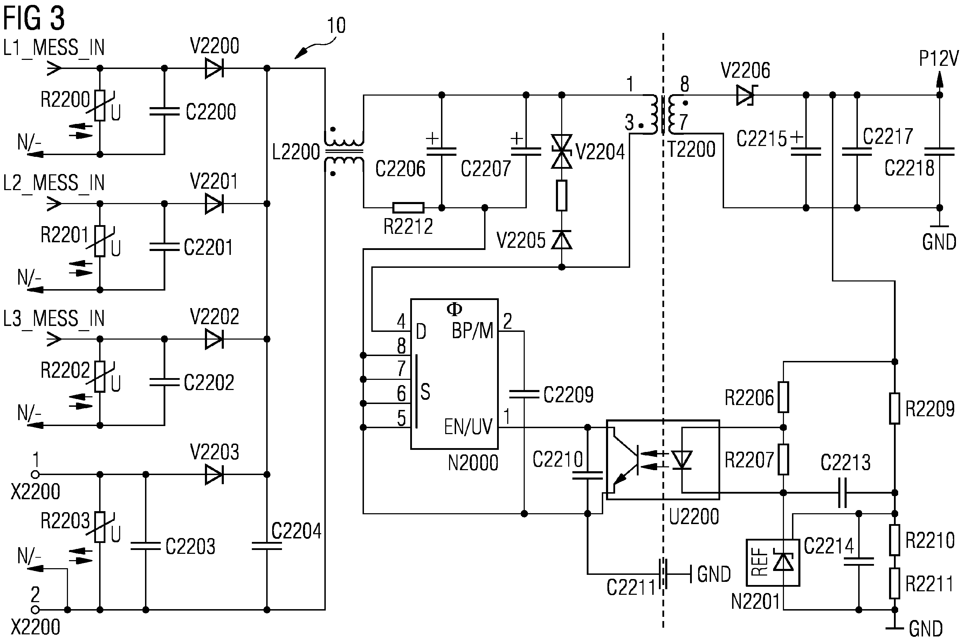

Fig. 3 zeigt eine mögliche Realisierung der Energieversorgung von Fig. 2 mit weiteren Details zu den Schaltungen 42 und 43 mit ohmschen Widerständen R2200-R2203, R2206, R2207 und R2209-R2212, Kondensatoren C2200-C2203, C2206, C2207, C2209 - C2211, C2213-C2215, C2217 und C2218, Spulen mit ferromagnetischem Kern L2200, Chips N2000 und N2201, einem Optokoppler U2200 und einem Transformator T2200. Konkret handelt es sich um eine Realisierung mit einem Flyback-Wandler bzw. Sperrwandler. Realisierungen mit anderen Gleichspannungswandertypen sind aber genauso vorstellbar.

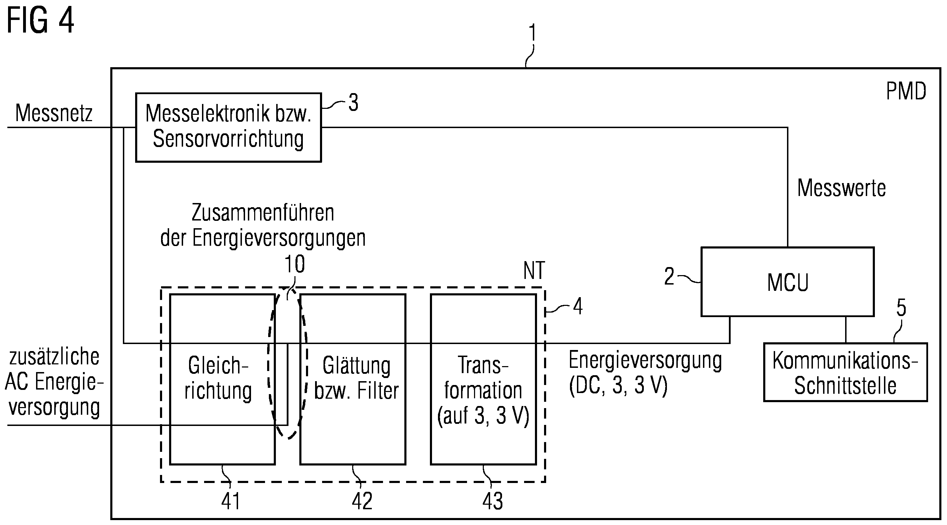

Fig. 4 zeigt eine Prinzipdarstellung einer erfindungsgemäßen Energieversorgung bei einem Messgerät gem. Fig 1. Es ist eine zusätzliche Wechselspannungsenergiequelle vorgesehen. Nach Gleichrichtung (Funktionsblock 41) werden die primäre und die zusätzliche Energieversorgung zusammengeführt (Bezugszeichen 10) und anschließend Funktionsblöcken zur Filterung bzw. Glättung 42 und zur Transformation 43 zugeführt, womit eine Gleichspannungsversorgung mit 3,3 V für die MCU 2 realisiert ist.

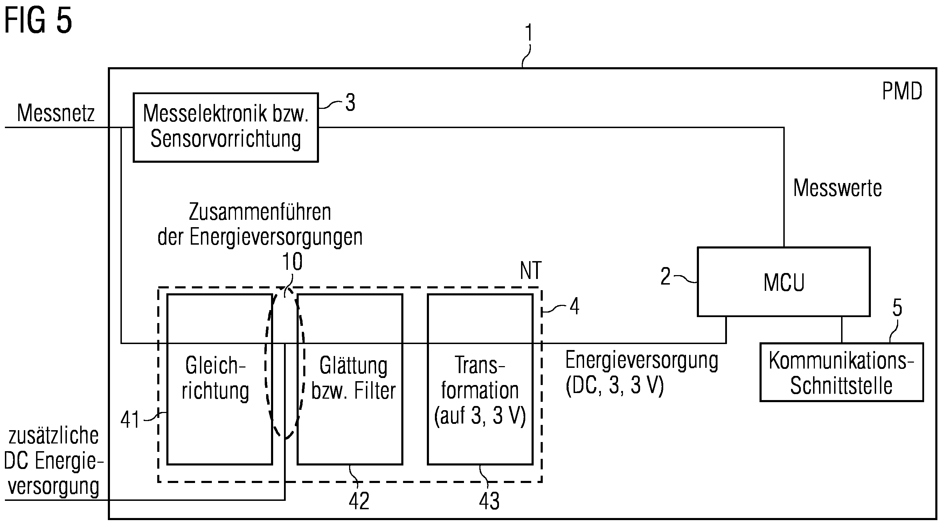

Die zusätzliche Spannungsquelle kann auch eine Gleichspannungsquelle sein. Dies in Fig. 5 veranschaulicht. In diesem Fall entfällt die Gleichrichtung. Es können aber der Zusammenschaltung vorgelagert Schaltelemente z.B. zum Schutz der Gesamtschaltung vorgesehen sein.

## Patentansprüche

1. Versorgungsschaltung (4) für ein Messgerät (1),
mit Eingängen einer primären Energieversorgung (L1, L2, L3, N) und einer zusätzlichen Energieversorgung (L_{AUX} N_{AUX}),
**dadurch gekennzeichnet, dass**
beide Energieversorgungen in der Versorgungsschaltung (4) zu einem Versorgungssignal zusammengeschaltet sind.

2. Versorgungsschaltung (4) nach Anspruch 1,
**dadurch gekennzeichnet, dass**
- die Eingänge (L1, L2, L3, N, L_{AUX}, N_{AUX}) der Energieversorgungen jeweils wenigstens einen Phasenleiter und einen Neutralleiter umfassen, und
- die Zusammenschaltung mittels Zusammenschaltung jeweils der Phasenleiter (L1, L2, L3, L_{AUX}) und der Neutralleiter (N, N_{AUX}) der Energieversorgungen realisiert ist.

3. Versorgungsschaltung (4) nach Anspruch 2,
**dadurch gekennzeichnet, dass**
für wenigstens eine der Energieversorgungen zwischen den Eingängen und der Zusammenschaltung Schaltelemente (C1-C4, X1-X4) zum Schutz der Elektronik des Messgeräts (1) vorgesehen sind.

4. Versorgungsschaltung (4) nach Anspruch 2 oder 3,
**dadurch gekennzeichnet, dass**
mindestens eine der Energieversorgungen Wechselspannung liefert und für die wenigstens eine Energieversorgung zwischen den Eingängen und der Zusammenschaltung mindestens ein Schaltelement (D1-D4) zur Spannungsgleichrichtung vorgesehen ist.

5. Versorgungsschaltung (4) nach einem der vorhergehenden Ansprüche,
**dadurch gekennzeichnet, dass**
sie mit einem der Zusammenschaltung der Energieversorgungen nachgelagerten Schaltungsteil (42) zur Glättung und/oder Filterung des Versorgungssignals gebildet ist.

6. Versorgungsschaltung (4) nach einem der vorhergehenden Ansprüche,
**dadurch gekennzeichnet, dass**
sie mit einem der Zusammenschaltung der Energieversorgungen nachgelagerten Schaltungsteil (43) zur Transformation des Versorgungssignals gebildet ist.

7. Messgerät (1) mit einer Versorgungsschaltung (4) nach einem der Ansprüche 1 bis 6.

8. Messgerät (1) nach Anspruch 7,
**dadurch gekennzeichnet, dass**
- das Messgerät (1) dafür ausgestaltet ist, auf einen Stromkreis bezogene Messdaten zu erfassen, und
- als primäre Energieversorgung dem Stromkreis Energie zu entnehmen.
